# EUROPÄISCHE PATENTSCHRIFT

(11) **EP 2 726 889 B1**
(45) Veröffentlichungstag und Bekanntmachung des Hinweises auf die Patenterteilung: **27.05.2015**
(21) Anmeldenummer: 12728086.5
(22) Anmeldetag: 19.06.2012
(51) Int. Cl.: G01R 31/40

(54) **PHOTOVOLTAIK-MODUL**
PHOTOVOLTAIC MODULE
MODULE PHOTOVOLTAÏQUE

(30) Priorität: 29.06.2011 DE 102011107365
(43) Veröffentlichungstag der Anmeldung: 07.05.2014
(73) Patentinhaber: eSYZz UG (haftungsbeschränkt), 12309 Berlin (DE)
(72) Erfinder: BERG, Dieter, 15230 Frankfurt (DE)
(74) Vertreter: Patentanwälte Bressel und Partner mbB
(86) Internationale Anmeldenummer: PCT/EP2012/061671
(87) Internationale Veröffentlichungsnummer: WO 2013/000762

(56) Entgegenhaltungen:
- EP-A1- 2 284 908
- US-A1- 2001 023 703
- US-A1- 2010 201 493
- US-A1- 2011 141 644
- US-B1- 6 515 215

## Beschreibung

Die Erfindung betrifft ein Photovoltaik-Modul gemäß dem Oberbegriff des Anspruchs 1.

Photovoltaik-Module umfassen mindestens eine Solarzelle und eine Anschlussdose, wobei die Anschlussdose die Spannungsausgänge des Photovoltaik-Moduls aufweist. Üblicherweise weist das Photovoltaik-Modul eine Vielzahl von Solarzellen auf, die in Reihe und/oder parallel zu einem so genannten String verschaltet sind, wobei dann die beiden Enden des Strings zur Anschlussdose geführt sind. In den bekannten Solaranlagen können dann auch mehrere Photovoltaik-Module zu einem oder mehreren Strings verschaltet werden.

Im Fall von Wohnungs- oder Hausbränden muss die Feuerwehr dafür sorgen, dass der Einsatzort strom- und spannungslos geschaltet ist, damit zum Beispiel bei Einsatz von Löschmitteln keine Verletzungen durch Stromschläge oder Lichtbögen erfolgen. Dokument US 6515215 B1 und Dokument US 2001/023703 A beschreiben Photovoltaik-Module.

Die DE 10 2005 018 173 A1 offenbart ein Verfahren zur sicheren Betriebsunterbrechung einer Photovoltaikanlage mit einer Schutzeinrichtung, welche an die Anschlüsse der Solaranlage angeschlossen ist und einen Bypass zum Kurzschließen der Photovoltaikanlage aufweist. Dieser Bypass kann manuell oder automatisch ausgelöst werden. Je nach Dimension der Photovoltaikanlage können hohe Ströme zu den Verbrauchern bzw. über den Bypass fließen, die im Falle der Auslösung der Schutzeinrichtung beherrscht werden müssen. Daher muss die Schutzeinrichtung entsprechend groß dimensioniert sein. Die Schaltung ist komplett mit elektronischen Halbleiterbauelementen aufgebaut. Die Anlage ist daher nicht galvanisch von den Verbrauchern getrennt. Die automatische Auslösung erfolgt dabei über eine Steuerleitung, über die die Schutzeinrichtung mit einer entfernt angeordneten Auslöseeinrichtung verbunden ist, so dass bei einer defekten Steuerleitung keine Trennung der Anlage stattfindet.

Aus der DE 20 2007 002 077 U1 ist eine Notabschaltung für Solarstromanlagen bekannt, wobei über eine von einem Netzanschluss zu einer Schaltbox geführte. Steuerleitung Abschaltbefehle übertragen werden, wenn eine Abschaltung des Netzes erfasst wird. Auch hier stellt sich das Problem, dass bei einer fehlerhaften Steuerleitung keine Trennung erfolgt.

Aus der DE 10 2009 022 508 A1 ist eine Safety-Schaltanlage für eine Photovoltaikanlage bekannt, wobei die Photovoltaikanlage aus mindestens einem Photovoltaikelement, zwei Anschlüssen zu je einer Zuleitung zu einem Verbraucher besteht, mit einem Bypass, welcher zwischen den beiden Anschlüssen und vor dem mindestens einen Schaltmechanismus angeordnet ist und mindestens einen Schaltmechanismus zum Schließen von Kontaktstellen aufweist, wobei in jeder der beiden Zuleitungen mindestens ein weiterer Schaltmechanismus zum Öffnen von Kontaktstellen angeordnet ist, wobei der mindestens eine Schaltmechanismus im Bypass und die in jeder Zuleitung der Photovoltaikanlage sich befindenden weiteren Schaltmechanismen dergestalt angeordnet und über eine Kopplung gemeinsam betätigbar sind, dass beim Betätigen der Safety-Schaltanlage zuerst die Kontaktstellen des mindestens einen Schaltmechanismus in jeder der beiden Zuleitungen geöffnet und anschließend mit einer zeitlichen Verzögerung die Kontaktstellen des mindestens einen Schaltmechanismus, der sich in dem Bypass befindet, geschlossen werden. Dabei erfolgt die Betätigung des Schaltmechanismus mechanisch durch eine Handhabe oder ferngesteuert durch einen Auslöser, der beispielsweise durch einen mit dem Hausnetz elektrisch verbundenen Unterspannungsauslöser gebildet wird.

Aus der DE 10 2008 003 272 A1 ist ein gattungsgemäßes Photovoltaik-Modul bekannt, wobei in einer Anschlussdose des Photovoltaik-Moduls eine Funktionsmodul-Platine angeordnet ist, auf welcher eine Vielzahl von Funktionsüberwachungsmodulen angeordnet sind. Ein solches Funktionsüberwachungsmodul ist ein Leistungsmodul, mit dem Strom und Spannung des jeweiligen Photovoltaik-Moduls überwacht wird, um so eine Aussage über die Funktion des Photovoltaik-Moduls zu erhalten. Die Überwachung der Leistung dient dabei Dokumentations- und Anlagen-Auslegungszwecken. Des Weiteren sind die Photovoltaik-Module mit einer drahtgebundenen Schnittstelle oder einer Luftschnittstelle zur Kommunikation mit einem Server ausgebildet. Weiter ist vorgesehen, dass von dem zentralen Server aus sehr einfach jedes individuelle Photovoltaik-Modul eines Strings abgetrennt werden kann, indem ein Abschaltmodul vorhanden ist, welches von dem auf einem Funktionsmodul angeordneten Mikroprozessor angesteuert wird. Im Brandfall ist es deshalb notwendig, dass vom Server aus über ein entsprechendes Abschaltsignal das jeweils individuelle Photovoltaik-Modul abgeschaltet wird, weil der entsprechende Abschaltbefehl drahtgebunden oder über Funkübertragung an das jeweils individuelle Photovoltaik-Modul übermittelt wurde.

Der Erfindung liegt das technische Problem zugrunde, ein Photovoltaik-Modul zu schaffen, das bei einfachem Aufbau eine sichere Abschaltung im Fall eines nicht verbauten oder angeschlossenen Moduls oder im Fehlerfall gewährleistet.

Die Lösung des technischen Problems ergibt sich durch die Gegenstände mit den Merkmalen des Anspruchs 1. Weitere vorteilhafte Ausgestaltungen der Erfindung ergeben sich aus den Unteransprüchen.

Hierzu umfasst das Photovoltaik-Modul mindestens eine Solarzelle und eine Anschlussdose, wobei die Anschlussdose die Spannungsausgänge des Photovoltaik-Moduls aufweist, wobei in oder an der Anschlussdose eine Auswerte- und Steuereinheit angeordnet ist, die eine Spannung und/oder einen Strom des Photovoltaik-Moduls erfasst, wobei dem Photovoltaik-Modul mindestens ein Schaltelement zugeordnet ist, das von der Auswerte- und Steuereinheit ansteuerbar ist, wobei mittels des Schaltelements das Photovoltaik-Modul abschaltbar ist, wobei die Auswerte- und Steuereinheit derart ausgebildet ist, dass anhand der erfassten Spannung und/oder des erfassten Stroms ein Fehlerzustand detektierbar ist und das Schaltelement unmittelbar aufgrund des erfassten Zustands durch die Auswerte- und Steuereinheit ansteuerbar ist, um den mindestens einen der Spannungsausgänge des Photovoltaik-Moduls oder der Baugruppe mittels des Schaltelements abzuschalten oder kurzzuschließen. Hierdurch wird erreicht, dass sowohl die Erfassung als auch das Abschalten der Spannung lokal am Photovoltaik-Modul selbst erfolgt, so dass hierfür keine Kommunikation mit einer zentralen Steuereinheit oder einer sonstigen Zentrale notwendig ist. Durch diesen Entfall der Kommunikationsstrecke wird die Zuverlässigkeit erhöht. Dabei sei angemerkt, dass der Fehlerzustand auch Zustände umfasst, bei denen das Photovoltaik-Modul nicht verbaut oder angeschlossen ist, wie beispielsweise bei einem Transport oder Montage. Auch in diesen Situationen schaltet sich das Photovoltaik-Modul selbsttätig ab. Die Abschaltung des Photovoltaik-Moduls kann dabei durch Abschalten bzw. Trennen eines Spannungsausganges erfolgen oder aber durch Kurzschließen der Spannungsausgänge. In jedem Fall ist sicherer Berührschutz gegeben. Aufgrund der Tatsache, dass das Photovoltaik-Modul autark die eigene Absicherung vornimmt, kann das erfindungsgemäße Photovoltaik-Modul flexibel mit den verschiedensten Umrichtern verbaut werden. Dabei kann durch Auswertung von Spannung und/oder Strom sehr einfach detektiert werden, ob ein angeschlossener Umrichter DC- oder AC-seitig abgeschaltet ist oder ein Kurzschluss zwischen Photovoltaik-Modul(en) und Umrichter aufgetreten ist bzw. ob das Photovoltaik-Modul überhaupt verbaut ist. Dabei kann die Auswerte- und Steuereinheit in der Anschlussdose integriert sein oder aber auch an dieser als Baugruppe angeordnet sein, so dass auch sehr einfach eine Nachrüstung vorhandener Module möglich ist. In diesem Fall werden die Spannungsausgänge des Photovoltaik-Moduls auf die Baugruppe geführt und dessen Spannungsausgang bzw. Spannungsausgänge im Fehlerfall abgeschaltet bzw. kurzgeschlossen. In beiden Fällen wird jedoch lokal am Photovoltaik-Modul der Fehlerfall detektiert und lokal und autark ohne zentrale Steuereinheit oder Zentrale die Spannung abgeschaltet. Dabei sei angemerkt, dass vorzugsweise die Auswertung Spannung und Strom des Photovoltaik-Moduls umfasst. Weiter vorzugsweise umfasst die Baugruppe neben der Auswerte- und Steuereinheit auch das mindestens eine Schaltelement.

In einer weiteren Ausführungsform erfasst und wertet die Auswerte- und Steuereinheit die Größe und/oder Form der Spannung und/oder des Stroms aus. So kann anhand der Größe beispielsweise ein Arbeitspunkt des Photovoltaik-Moduls bestimmt werden. Liegt dann beispielsweise der Arbeitspunkt im Leerlauf oder im Kurzschluss, so kann auf einen Fehler geschlossen werden. Über die Form, vorzugsweise die Welligkeit, kann geschlossen werden, ob ein Umrichter angeschlossen ist oder nicht, da dessen Taktung zu einer Welligkeit von Strom und Spannung führt.

Mittels der Prüfeinrichtung des Anspruchs 1 kann dabei im abgeschalteten Zustand überprüft werden, ob das Photovoltaik-Modul an einen Umrichter angeschlossen und/oder ein Fehlerfall noch vorliegt oder behoben ist, wobei bei Erfassung eines angeschlossenen Umrichters bzw. behobenen Fehlerfall der Spannungsausgang eingeschaltet werden kann. Das Photovoltaik-Modul kann sich also nicht nur selbst abschalten, sondern auch wieder selbst einschalten. Dabei sei angemerkt, dass die Prüfeinrichtung vorzugsweise auch Bestandteil der Baugruppe ist. Weiter sei angemerkt, dass die Prüfeinrichtung vollständig oder teilweise in die Auswerte- und Steuereinheit integriert sein kann.

In einer weiteren Ausführungsform ist mittels der Prüfeinrichtung ein zeitlich veränderliches Prüfsignal aufprägbar. Dies erlaubt eine bessere Beurteilung, um beispielsweise festzustellen, dass ein abgeschalteter Umrichter wieder eingeschaltet ist, dessen Eingangskapazitäten aber bereits geladen sind, was beispielsweise bei einer statischen Prüfspannung gegebenenfalls nicht detektierbar ist.

In einer weiteren Ausführungsform erfolgt eine Spannungsversorgung der Auswerte- und Steuereinheit und/oder der Prüfeinrichtung durch das Photovoltaik-Modul. Dadurch sind separate Energiespeicher oder Spannungsversorgungen entbehrlich. Dabei ergibt sich auch keine Einbuße an Sicherheit, da, wenn das Photovoltaik-Modul keine Spannung erzeugt, die Spannungsausgänge auch nicht abgeschaltet werden müssen. Gegebenenfalls wandelt ein DC/DC-Wandler oder ein Spannungsbegrenzer die Spannung des Photovoltaik-Moduls auf eine geeignete Höhe der Versorgungsspannung herunter.

In einer weiteren Ausführungsform ist das Schaltelement als Leistungsrelais ausgebildet, mittels dessen eine galvanische Trennung ermöglicht wird.

In einer weiteren Ausführungsform ist das Photovoltaik-Modul bzw. die Baugruppe allpolig abschaltbar, d.h. beide Spannungsausgänge werden abgeschaltet bzw. aufgetrennt.

In einer weiteren Ausführungsform ist das Schaltelement im Ruhezustand offen, d.h. wenn keine Spannung zur Versorgung vorhanden ist, ist der Spannungsausgang abgeschaltet. Dies erhöht weiter die Sicherheit. Dabei kann vorgesehen sein, dass, wenn das Photovoltaik-Modul wieder Spannung erzeugt, zunächst über die Prüfeinrichtung kontrolliert wird, ob kein Fehlerfall vorliegt, bevor der oder die Spannungsausgänge freigeschaltet werden. Auch diese Maßnahme erhöht die Sicherheit weiter. Entsprechend ist bei der Abschaltung des Photovoltaik-Moduls durch Kurzschluss der Spannungsausgänge das Schaltelement im Ruhezustand vorzugsweise geschlossen.

In einer weiteren Ausführungsform ist der Auswerte- und Steuereinheit ein Speicherelement für die Versorgungsspannung zugeordnet, insbesondere um bei Ausfall der Spannung des Photovoltaik-Moduls einen sicheren Nachlauf zu gewährleisten und sich selbst ordnungsgemäß abzuschalten.

In einer weiteren Ausführungsform ist dem Photovoltaik-Modul eine Signalisierungs- und/oder Kommunikationseinheit zugeordnet, mittels derer das Photovoltaik-Modul seinen Zustand signalisiert.

Die Erfindung wird nachfolgend anhand bevorzugter Ausführungsbeispiele näher erläutert. Die Fig. zeigen:
- Fig. 1: ein schematisches Blockschaltbild eines Photovoltaik-Moduls mit einer externen Baugruppe,
- Fig. 2: ein schematisches Blockschaltbild eines Photovoltaik-Moduls mit einer integrierten Auswerte- und Steuereinheit in einer Anschlussdose des Photovoltaik-Moduls,
- Fig. 3: schematische Strom- und Spannungsverläufe beim Prüfen des fehlerfreien Anschluss an einen Umrichter, zum Einschalten des Photovoltaik-Moduls
- Fig. 4: schematische Strom- und Spannungsverläufe für einen Leerlauffall,
- Fig. 5: schematische Strom- und Spannungsverläufe für einen Kurzschlussfall und
- Fig. 6: eine schematische Darstellung der Vorschaltung von Photovoltaik-Modulen mit einem Umrichter.

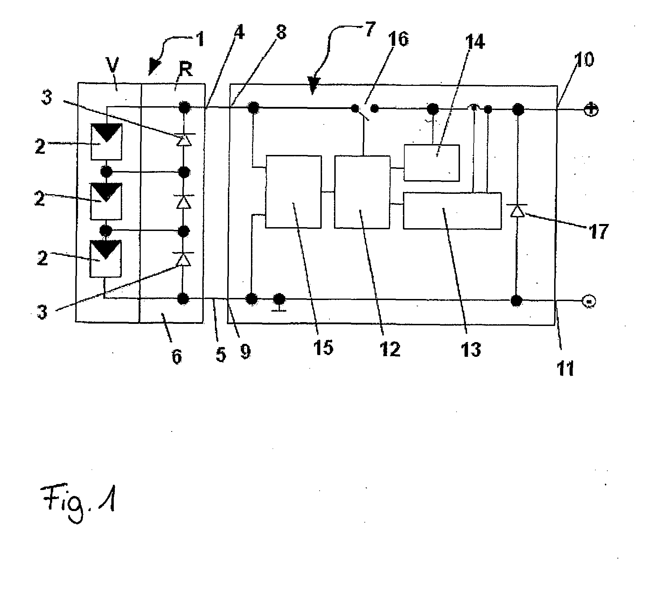

In Fig. 1 ist eine erste Ausführungsform der Erfindung dargestellt. Dabei ist schematisch ein Photovoltaik-Modul 1 dargestellt, das auf seiner Vorderseite V drei Solarzellen 2 aufweist, die in Reihe zu einem String verschaltet sind. Die Anschlüsse der Solarzellen 2 sind zu einer Rückseite R des Photovoltaik-Moduls 1 geführt, wo Bypass-Dioden 3 angeordnet sind, die auch bei Ausfall einer Solarzelle 2 den Stromfluss durch den String gewährleisten. Aus der Rückseite R sind Spannungsausgänge 4, 5 des Photovoltaik-Moduls 1 herausgeführt. Die Bypass-Dioden 3 und die Spannungsausgänge 4, 5 sind in einer Anschlussdose 6 angeordnet, die von der Rückseite R zugänglich ist. Lokal an dem Photovoltaik-Modul 1 ist eine Baugruppe 7 angeordnet. Die Baugruppe 7 umfasst zwei Spannungseingänge 8, 9 und zwei Spannungsausgänge 10, 11. Weiter umfasst die Baugruppe 7 eine Auswerte- und Steuereinheit 12, eine Messeinrichtung 13, eine Prüfeinrichtung 14, eine interne Spannungsversorgung 15, ein Schaltelement 16 und eine Diode 17. Dabei ist jeweils ein Spannungsausgang 4, 5 des Photovoltaik-Moduls 1 mit einem Spannungseingang 8, 9 der Baugruppe 7 verbunden. Das mindestens eine Schaltelement 16 liegt zwischen dem Spannungseingang 8 und dem Spannungsausgang 10 und wird durch die Auswerte- und Steuereinheit 12 angesteuert. Die interne Spannungsversorgung 15 ist mit den Spannungseingängen 8, 9 verbunden und wird somit direkt vom Photovoltaik-Modul 1 gespeist. Die interne Spannungsversorgung 15 versorgt die elektronischen Komponenten mit Spannung, wobei in der Fig. 1 nur die Verbindung zur Auswerte- und Steuereinheit 12 dargestellt ist. Die Messeinrichtung 13 erfasst Spannung und Strom am Spannungsausgang 10,11 der Baugruppe 7.

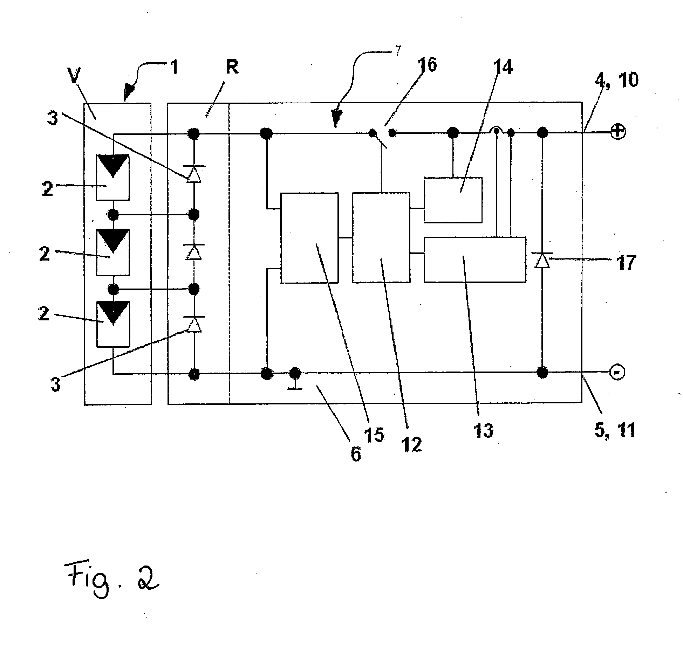

In der Fig. 2 ist eine alternative Ausführungsform dargestellt, bei der die Baugruppe 7 in die Anschlussdose 6 des Photovoltaik-Moduls 1 integriert ist. Somit sind die Spannungsausgänge 4, 5 gleich den Spannungsausgängen 10, 11 der Baugruppe 7. Ansonsten kann vollinhaltlich auf die Ausführungen zu Fig. 1 verwiesen werden.

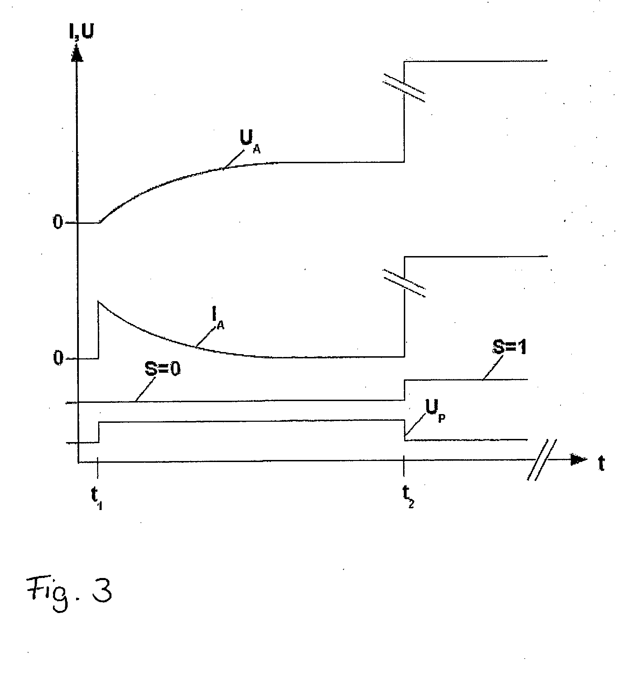

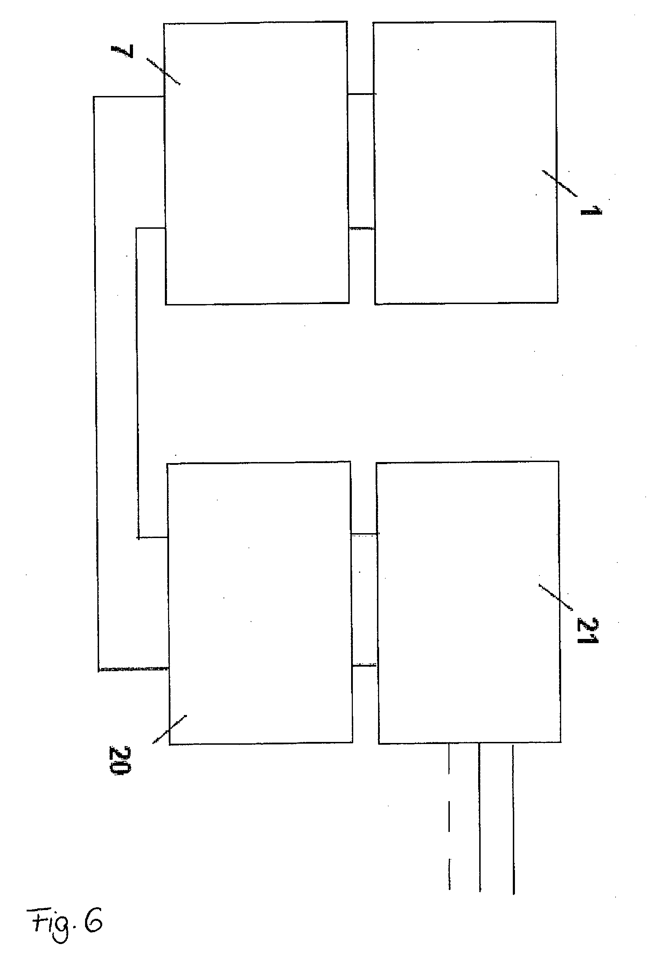

Bevor die Wirkungsweise des erfindungsgemäßen Photovoltaik-Moduls 1 mit interner oder externer Baugruppe 7 anhand der Fig. 3 bis 5 näher erläutert wird, soll kurz anhand der Fig. 6 ein Teil einer Solaranlage näher erläutert werden.

Das Photovoltaik-Modul 1 ist dabei mit einer externen Baugruppe 7 dargestellt. Die Spannungsausgänge 10, 11 der Baugruppe 7 sind mit einem DC-Freischalter 20 verbunden, der mit einem Umrichter 21 verbunden ist. Am Ausgang des Umrichters 21 ist das Netz, das als 1- oder Mehrphasiges Wechselspannungsnetz oder als Gleichspannungsnetz ausgebildete sein kann. Über den DC-Freischalter 20 können ein oder mehrere Photovoltaik-Module 1 oder Strings von Photovoltaik-Modulen 1 auf den Umrichter 21 geschaltet werden bzw. auch abgeschaltet werden. Dabei sei angemerkt, dass aufgrund der erfindungsgemäßen individuellen Abschaltbarkeit der Photovoltaik-Module 1 der DC-Freischalter 20 technisch auch entfallen kann.

Die Fig. 3 bis 5 werden nun im Zusammenhang mit Fig. 1 näher erläutert. Dabei sei angenommen, dass das Photovoltaik-Modul 1 zunächst keine Spannung erzeugt, beispielsweise weil es Nacht ist. Entsprechend wird die Baugruppe 7 nicht mit Spannung versorgt und das Schaltelement 16 ist offen (S = 0). Entsprechend ist die Spannung an den Spannungsausgängen 10, 11 null (U_{A} = 0). Erzeugt dann das Photovoltaik-Modul 1 wieder Spannung, so wird die Baugruppe 7 mit Spannung versorgt, wobei zunächst das Schaltelement 16 offen bleibt. Die Prüfeinrichtung 14 legt dann zum Zeitpunkt t₁ eine kleine Prüfspannung U_{P} von beispielsweise 2 V auf den Spannungsausgang 10 an. Der in Fig. 6 erläuterte Umrichter weist dabei eine Eingangskapazität auf. Ist also der DC-Freischalter 20 geschlossen und der Umrichter 21 angeschlossen, so wird durch die Prüfspannung die Eingangskapazität des Umrichters 21 aufgeladen. Entsprechend fließt zunächst ein großer Ausgangsstrom I_{A}, der exponentiell abfällt. Entsprechend steigt die Spannung U_{A} an und ist schließlich gleich der Prüfspannung. Aus dem Verlauf von Spannung und Strom, gemessen durch die Messeinrichtung 13, erkennt die Auswerte- und Steuereinheit 12, dass der Umrichter 21 angeschaltet bzw. nicht angeschaltet ist. Im ersten Fall wird dann zum Zeitpunkt t₂ das Schaltelement 16 geschlossen (S = 1). Ohne angeschalteten Umrichter bleibt das Schaltelement 16 hingegen offen und somit der Spannungsausgang abgeschaltet. Dabei kann vorgesehen sein, dass die Prüfeinrichtung 14 eine zeitlich veränderbare Prüfspannung generiert, so dass auch vorgeladene Kapazitäten des Umrichters 21 erfasst werden. Wenn das Schaltelement 16 geschlossen wird (S = 1), wird die Prüfspannung U_{P} abgeschaltet (U_{P} = 0).

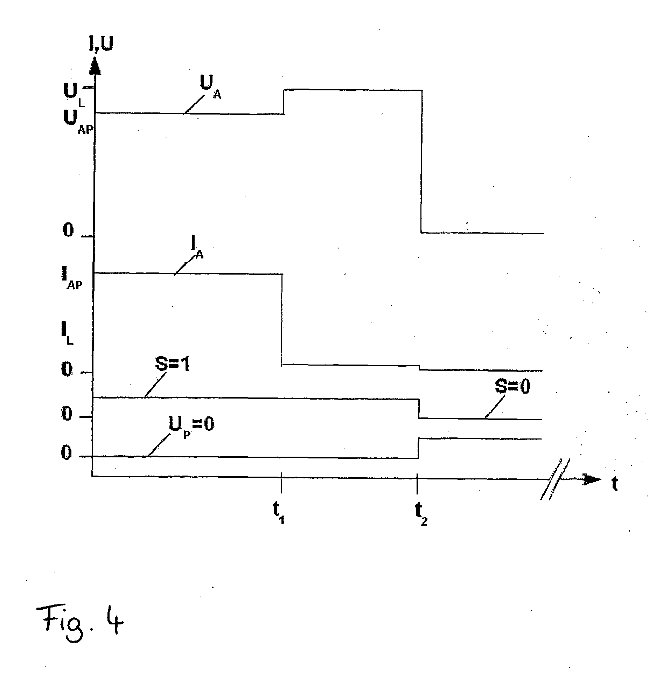

In Fig. 4 ist ein Strom- und Spannungsverlauf dargestellt, bei dem ein Leerlauffall detektiert wird. Dabei arbeitet das Photovoltaik-Modul 1 in einem Arbeitspunkt U_{AP}, I_{AP}. Die Werte für Spannung und Strom werden dabei durch die Messeinrichtung 13 überwacht. Zum Zeitpunkt t₁ erfasst dann die Messeinrichtung 13, dass die Spannung U_{A} auf die Leerlaufspannung U_{L} angestiegen ist und der Strom I_{A} auf I_{L} gesunken ist. Dieses Verhalten wird von der Auswerte- und Steuereinheit 12 als Leerlauffall interpretiert, der beispielsweise dadurch auftritt, dass das Netz am Umrichter 21 abgeschaltet wurde. In diesem Fall fließt dann nur ein kleiner Leerlaufstrom I_{L} zur Grundversorgung des Umrichters 21. Nachdem die Auswertung abgeschlossen ist, öffnet die Auswerte- und Steuereinheit 12 zum Zeitpunkt t₂ das Schaltelement 16 (S = 0). Der Spannungsausgang 10 ist also abgeschaltet und es gilt: U_{A} = I_{A} = 0. Anschließend wird eine Prüfspannung U_{P} aufgeschaltet, um festzustellen, ob das Netz wieder zugeschaltet wird bzw. anderweitig die Fehlerursache behoben wurde. Dabei sei angemerkt, dass die Prüfspannung U_{P} nicht permanent anliegen muss, sondern auch periodisch aufgeschaltet werden kann.

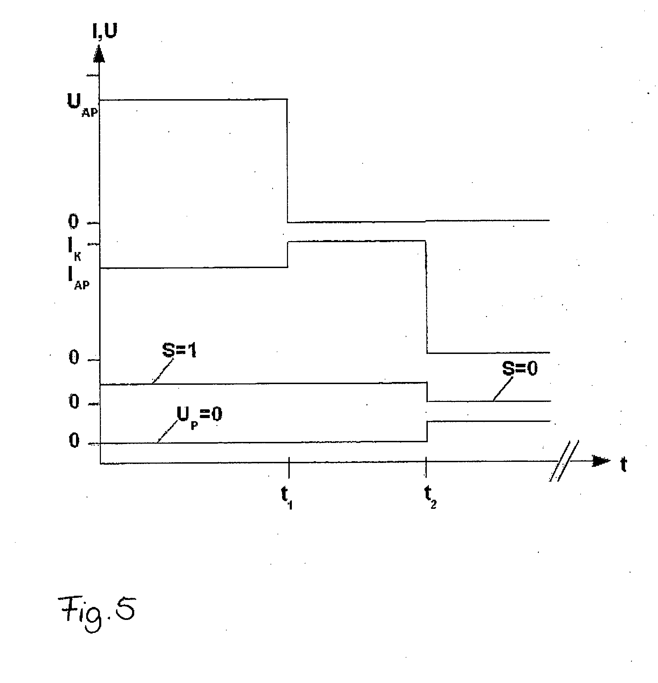

In Fig. 5 ist ein Strom- und Spannungsverlauf dargestellt, bei dem ein Kurzschluss detektiert wird. Dabei arbeitet das Photovoltaik-Modul 1 in einem Arbeitspunkt U_{AP}, I_{AP}. Die Werte für Spannung und Strom werden dabei durch die Messeinrichtung 13 überwacht. Zum Zeitpunkt t₁ erfasst dann die Messeinrichtung 13, dass die Spannung auf U_{A} = 0 sinkt und gleichzeitig der Strom auf I_{K} ansteigt. Dieses Verhalten wird von der Auswerte- und Steuereinheit 12 als Kurzschlussfehler interpretiert. Als Reaktion öffnet die Auswerte- und Steuereinheit 12 zum Zeitpunkt t₂ das Schaltelement 16 (S = 0), so dass der Spannungsausgang 10 abgeschaltet wird. Es gilt U_{A} = I_{A} = 0. Anschließend wird wieder die Prüfspannung U_{P} aufgeschaltet. Dabei sei angemerkt, dass U_{P} sehr klein gegenüber U_{AP} ist, so dass die resultierende Spannung und Strom vernachlässigbar sind, da aufgrund der Prüfspannung U_{P} U_{A} = I_{A} = 0 streng genommen nicht gilt.

## Patentansprüche

1. Photovoltaik-Modul (1), umfassend mindestens eine Solarzelle (2) und eine Anschlussdose (6), wobei die Anschlussdose (6) die Spannungsausgänge (4, 5) des Photovoltaik-Moduls (1) aufweist, wobei in oder an der Anschlussdose (6) als Baugruppe (7) eine Auswerte- und Steuereinheit (12) angeordnet ist, die eine Spannung (U_{A}) und/oder einen Strom (I_{A}) des Photovoltaik-Moduls (1) erfasst, wobei dem Photovoltaik-Modul (1) mindestens ein Schaltelement (16) zugeordnet ist, das von der Auswerte- und Steuereinheit (12) ansteuerbar ist, wobei mittels des Schaltelements (16) das Photovoltaik-Modul (1) abschaltbar ist, wobei die Auswerte- und Steuereinheit (12) derart ausgebildet ist, dass anhand der erfassten Spannung (U_{A}) und/oder des erfassten Stroms (I_{A}) ein Fehlerzustand detektierbar ist und das Schaltelement (16) aufgrund des erfassten Fehlerzustandes durch die Auswerte- und Steuereinheit (12) ansteuerbar ist, um mindestens einen der Spannungsausgänge (4, 5 ; 10, 11) des Photovoltaik-Moduls (1) oder der Baugruppe (7) abzuschalten oder kurzzuschließen,
**dadurch gekennzeichnet, dass**
der Auswerte- und Steuereinheit (12) eine Prüfeinrichtung (14) zugeordnet ist, mittels derer ein Prüfsignal auf einen abgeschalteten Spannungsausgang (10) aufprägbar und mindestens ein Messsignal erfassbar ist, wobei in Abhängigkeit des Messsignals die Auswerte- und Steuereinheit (12) das Schaltelement (16) ansteuert.

2. Photovoltaik-Modul nach Anspruch 1, **dadurch gekennzeichnet, dass** die Auswerte- und Steuereinheit (12) die Größe und/oder Form der Spannung (U_{A}) und/oder des Stromes (I_{A}) erfasst und auswertet.

3. Photovoltaik-Modul nach Anspruch 2, **dadurch gekennzeichnet, dass** mittels der Prüfeinrichtung (14) ein zeitlich veränderliches Prüfsignal aufprägbar ist.

4. Photovoltaik-Modul nach einem der vorangegangenen Ansprüche, **dadurch gekennzeichnet, dass** eine Spannungsversorgung der Auswerte- und Steuereinheit (12) und/oder der Prüfeinrichtung (14) durch das Photovoltaik-Modul (1) erfolgt.

5. Photovoltaik-Modul nach einem der vorangegangenen Ansprüche, **dadurch gekennzeichnet, dass** das Schaltelement (16) als Leistungs-Relais ausgebildet ist.

6. Photovoltaik-Modul nach einem der vorangegangenen Ansprüche, **dadurch gekennzeichnet, dass** das Photovoltaik-Modul (1) allpolig abschaltbar ist.

7. Photovoltaik-Modul nach einem der vorangegangenen Ansprüche, **dadurch gekennzeichnet, dass** das Schaltelement (16) im Ruhezustand offen ist.

8. Photovoltaik-Modul nach einem der vorangegangenen Ansprüche, **dadurch gekennzeichnet, dass** der Auswerte- und Steuereinheit (12) ein Speicherelement für die Versorgungsspannung zugeordnet ist.

9. Photovoltaik-Modul nach einem der vorangegangenen Ansprüche, **dadurch gekennzeichnet, dass** dem Photovoltaik-Modul (1) eine Signalisierungs- und/oder Kommunikationseinheit zugeordnet ist.

## Claims

1. Photovoltaic module (1), comprising at least one solar cell (2) and a connection box (6), wherein the connection box (6) has the voltage outputs (4, 5) of the photovoltaic module (1), wherein an evaluation and control unit (12) is arranged in or on the connection box (6) as assembly (7), said evaluation and control unit detecting a voltage (U_{A}) and/or a current (I_{A}) of the photovoltaic module (1), wherein the photovoltaic module (1) is assigned at least one switching element (16) which is drivable by the evaluation and control unit (12), wherein the photovoltaic module (1) can be switched off by means of the switching element (16), wherein the evaluation and control unit (12) is designed in such a way that a fault state is detectable on the basis of the detected voltage (U_{A}) and/or the detected current (I_{A}) and the switching element (16) is drivable by the evaluation and control unit (12) on the basis of the detected fault state in order to switch off or short-circuit at least one of the voltage outputs (4, 5; 10, 11) of the photovoltaic module (1) or of the assembly (7),
**characterized in that**
the evaluation and control unit (12) is assigned a test device (14), by means of which a test signal can be impressed on a switched-off voltage output (10) and at least one measurement signal is detectable, wherein the evaluation and control unit (12) drives the switching element (16) depending on the measurement signal.

2. Photovoltaic module according to Claim 1, **characterized in that** the evaluation and control unit (12) detects and evaluates the magnitude and/or shape of the voltage (U_{A}) and/or of the current (I_{A}).

3. Photovoltaic module according to Claim 2, **characterized in that** a temporally variable test signal can be impressed by means of the test device (14).

4. Photovoltaic module according to any of the preceding claims, **characterized in that** a voltage supply of the evaluation and control unit (12) and/or of the test device (14) is effected by the photovoltaic module (1).

5. Photovoltaic module according to any of the preceding claims, **characterized in that** the switching element (16) is designed as a power relay.

6. Photovoltaic module according to any of the preceding claims, **characterized in that** the photovoltaic module (1) can be switched off at all poles.

7. Photovoltaic module according to any of the preceding claims, **characterized in that** the switching element (16) is open in the quiescent state.

8. Photovoltaic module according to any of the preceding claims, **characterized in that** the evaluation and control unit (12) is assigned a storage element for the supply voltage.

9. Photovoltaic module according to any of the preceding claims, **characterized in that** the photovoltaic module (1) is assigned a signalling and/or communication unit.

## Revendications

1. Module photovoltaïque (1), comprenant au moins une cellule solaire (2) et une prise de raccordement (6), la prise de raccordement (6) présentant les sorties de tension (4, 5) du module photovoltaïque (1), une unité d'analyse et de commande (12) étant disposée dans la prise de raccordement (6) ou au niveau de celle-ci sous la forme d'un module (7) détectant une tension (U_{A}) et/ou un courant (I_{A}) du module photovoltaïque (1), au moins un élément de connexion (16) étant associé au module photovoltaïque (1), ledit élément pouvant être excité par l'unité d'analyse et de commande (12), le module photovoltaïque (1) pouvant être déconnecté à l'aide de l'élément de connexion (16), l'unité d'analyse et de commande (12) étant réalisée de telle sorte qu'un état d'anomalie peut être détecté à l'aide de la tension détectée (U_{A}) et/ou du courant (I_{A}) et l'élément de connexion (16) pouvant être excité par l'unité d'analyse et de commande (12) sur la base de l'état d'anomalie détecté, pour déconnecter ou court-circuiter au moins une des sorties de tension (4, 5 ; 10, 11) du module photovoltaïque (1) ou du module (7), **caractérisé en ce qu'**un dispositif de contrôle (14) est associé à l'unité d'analyse et de commande (12), un signal de contrôle pouvant être marqué sur une sortie de tension (10) déconnectée à l'aide dudit dispositif et au moins un signal de mesure pouvant être déterminé, l'unité d'analyse et de commande (12) excitant l'élément de connexion (16) en fonction du signal de mesure.

2. Module photovoltaïque selon la revendication 1, **caractérisé en ce que** l'unité d'analyse et de commande (12) détecte et analyse la taille et/ou la forme de la tension (U_{A}) et/ou du courant (I_{A}).

3. Module photovoltaïque selon la revendication 2, **caractérisé en ce qu'**un signal de contrôle variant dans le temps peut être marqué à l'aide du dispositif de contrôle (14).

4. Module photovoltaïque selon l'une quelconque des revendications précédentes, **caractérisé en ce qu'**une alimentation en tension de l'unité d'analyse et de commande (12) et/ou du dispositif de contrôle (14) se produit par le biais du module photovoltaïque (1).

5. Module photovoltaïque selon l'une quelconque des revendications précédentes, **caractérisé en ce que** l'élément de connexion (16) prend la forme d'un relais de puissance.

6. Module photovoltaïque selon l'une quelconque des revendications précédentes, **caractérisé en ce que** le module photovoltaïque (1) est déconnecté au niveau de tous ses pôles.

7. Module photovoltaïque selon l'une quelconque des revendications précédentes, **caractérisé en ce que** l'élément de connexion (16) est ouvert à l'état de repos.

8. Module photovoltaïque selon l'une quelconque des revendications précédentes, **caractérisé en ce qu'**un élément d'accumulateur est associé à l'unité d'analyse et de commande (12) pour la tension d'alimentation.

9. Module photovoltaïque selon l'une quelconque des revendications précédentes, **caractérisé en ce qu'**une unité de signalisation et/ou de communication est associée au module photovoltaïque (1).
